# EUROPEAN PATENT APPLICATION

(11) **EP 3 565 228 A1**
(43) Date of publication of application: **06.11.2019**
(21) Application number: 16925167.5
(22) Date of filing: 28.12.2016
(51) Int. Cl.: H04M 1/725

(54) **INFORMATION PROCESSING METHOD AND APPARATUS**

(71) Applicant: Shenzhen Royole Technologies Co., Ltd., Shenzhen, Guangdong 518052 (CN)
(72) Inventor: ZHANG, Xuan, Shenzhen Guangdong 518052 (CN)
(74) Representative: Hamer, Christopher K.
(86) International application number: PCT/CN2016/112587
(87) International publication number: WO 2018/119732

(57) **Abstract**

An information processing method is provided. The information processing method is applicable to a mobile terminal provided with a first touch screen and a second touch screen, where the first touch screen is located on a front surface of the mobile terminal and the second touch screen is located on a rear surface or a side surface of the mobile terminal. The information processing method includes the following. A target control of an event to be executed is displayed on the second touch screen in response to an existence of a vertical downward component in a positive normal direction of the first touch screen. A determination is made on whether a rotation parameter value of the mobile terminal is greater than a preset rotation threshold value in response to receiving a touch instruction for the target control. The event to be executed is executed according to the touch instruction based on a determination that the rotation parameter value of the mobile terminal is greater than the preset rotation threshold value. An information processing device is also provided. According to embodiments of the present disclosure, a user can trigger a control for displaying a push message in the process of picking up a mobile phone since the control displayed on the second touch screen has been triggered by the user while handling the mobile phone and a rotation motion has been applied to the mobile phone, thereby simplifying process and offering convenience for the user.

## Description

### TECHNICAL FIELD

The present disclosure relates to a field of mobile terminals, and more particularly, to an information processing method and a device.

### BACKGROUND

With the development of the flexible display technology, cellphones with curved-sided screens have become more and more popular. Various new interaction modes have been emerged along with the curved-sided screens. The current curved-sided screen can be used to display push messages, status bars, directory controls, widgets, and the like.

In the prior art, although the side surface is capable of displaying push messages, status bars, directory controls, widgets, and the like, a user still needs to trigger corresponding controls to execute events to be executed through cumbersome steps.

For example, when a new message is pushed on the side surface, the user needs to pick up the mobile phone first, flip the mobile phone to render the front surface towards the user, unlock the screen and then click to trigger the corresponding push control of the new message so as to read the new message, which is very cumbersome.

### SUMMARY

Embodiments of the present disclosure provide an information processing method and device, to achieve technical effects of triggering a corresponding control for an event to be executed and executing a corresponding operation in the process of picking up a mobile terminal by a user, according to an operation of touching the control displayed on a side touch screen or a rear touch screen of a mobile phone by the user and a motion of rotating the mobile terminal, thereby simplifying process and offering convenience for users.

In a first aspect, an information processing method is provided, which is applicable to a mobile terminal provided with a first touch screen and a second touch screen, where the first touch screen is located on a front surface of the mobile terminal and the second touch screen is located on a rear surface or a side surface of the mobile terminal. The information processing method includes the following steps.

A target control of an event to be executed is displayed on the second touch screen in response to an existence of a vertical downward component in a positive normal direction of the first touch screen.

A determination may be made on whether a rotation parameter value of the mobile terminal is greater than a preset rotation threshold value in response to receiving a touch instruction for the target control.

The event to be executed is executed according to the touch instruction based on a determination that the rotation parameter value of the mobile terminal is greater than the preset rotation threshold value.

Combined with the first aspect, in a first possible implementation, the target control of the event to be executed may be displayed on the second touch screen as follows. A call answering control and a call declining control may be displayed on the second touch screen in response to receiving a call request. The event to be executed may be executed according to the touch instruction as follows. The call request is answered when the touch instruction is for triggering the call answering control; the call request is declined when the touch instruction is for triggering the call declining control.

Combined with the first aspect, in a second possible implementation, the target control of the event to be executed may be displayed on the second touch screen as follows. A push control for notifying a new message may be displayed on the second touch screen in response to receiving the new message. And the event to be executed may be executed according to the touch instruction as follows. The first touch screen may display contents of the new message received in response to a touch instruction for the push control for notifying the new message.

Combined with the first aspect, in a third possible implementation, the information processing method further includes the following steps.

A position adjusting instruction for the target control may be received.

A position of the target control displayed on the second touch screen of the mobile terminal may be adjusted in response to the position adjusting instruction.

Combined with the first aspect, in a fourth possible implementation, the target control of the event to be executed may be displayed on the second touch screen as follows. A first target control of the event to be executed may be displayed on the second touch screen disposed on the rear surface of the mobile terminal, and a second target control of the event to be executed may be displayed on the second touch screen disposed on the side surface of the mobile terminal; and the touch instruction for the target control includes a touch instruction for the first target control and a touch instruction for the second target control.

Combined with the fourth possible implementation of the first aspect, in a fifth possible implementation, a first target control of the event to be executed may be displayed as follows. A message sending control may be displayed on the second touch screen disposed on the rear surface of the mobile terminal. A second target control of the event to be executed may be displayed as follows. A contact control may be displayed on the second touch screen disposed on the side surface of the mobile terminal. And the event to be executed may be executed according to the touch instruction as follows. A message editing interface for sending a message to a target contact may be generated and displayed on the first touch screen in response to a touch instruction for the message sending control and the target contact selected via a touch instruction for the contact control.

In a second aspect, an information processing device is provided, which is applicable to a mobile terminal provided with a first touch screen and a second touch screen, where the first touch screen is located on a front surface of the mobile terminal and the second touch screen located on a rear surface or a side surface of the mobile terminal. The information processing device includes a display module, a touch instruction receiving module, a determining module, and an executing module.

The display module is configured to display a target control of an event to be executed on the second touch screen in response to an existence of a vertical downward component in a positive normal direction of the first touch screen.

The touch instruction receiving module is configured to receive a touch instruction for the target control.

The determining module is configured to determine whether a rotation parameter value of the mobile terminal is greater than a preset rotation threshold value in response to receiving the touch instruction for the target control by the touch instruction receiving module.

The executing module is configured to execute the event to be executed according to the touch instruction based on a determination result of the determining module that the rotation parameter value of the mobile terminal is greater than the preset rotation threshold value.

Combined with the second aspect, in a first possible implementation, the display module includes an answering display sub-unit and a declining display sub-unit. The answering display sub-unit is configured to display a call answering control in response to receiving a call request, and the declining display sub-unit is configured to display a call declining control in response to receiving the call request. The executing module includes an answering sub-unit and a declining sub-unit. The answering sub-unit is configured to answer the call request when the touch instruction is for triggering the call answering control, and the declining sub-unit is configured to decline the call request when the touch instruction is for triggering the call declining control.

Combined with the second aspect, in a second possible implementation, the display module includes a push control display sub-unit, which is configured to display a push control for notifying a new message in response to receiving the new message; and the executing module includes a message reading sub-unit, which is configured to display contents of the new message received on the first touch screen in response to a touch instruction for the push control for notifying the new message.

Combined with the second aspect, in a third possible implementation, which further includes an adjusting instruction receiving module and an adjusting module. The adjusting instruction receiving module is configured to receive a position adjusting instruction for the target control, and the adjusting module is configured to adjust a position of the target control displayed on the second touch screen of the mobile terminal according to the position adjusting instruction.

Combined with the second aspect, in a fourth possible implementation, the display module includes a first display sub-unit and a second display sub-unit. The first display sub-unit is configured to display a first target control of the event to be executed on the second touch screen disposed on the rear surface of the mobile terminal and the second display sub-unit is configured to display a second target control of the event to be executed on the second touch screen disposed on the side surface of the mobile terminal. And the touch instruction receiving module includes a first instruction receiving sub-unit and a second instruction receiving sub-unit. The first instruction receiving sub-unit is configured to receive a touch instruction for the first target control and the second instruction receiving sub-unit is configured to receive a touch instruction for the second target control.

Combined with the fourth possible implementation of the second inspect, in a fifth possible implementation, the first display sub-unit includes a message control secondary display sub-unit, which is configured to display a message sending control on the second touch screen disposed on the rear surface of the mobile terminal; the second display sub-unit includes a contact control secondary display sub-unit, which is configured to display a contact control on the second touch screen disposed on the side surface of the mobile terminal; and the executing module includes a message editing sub-unit, which is configured to generate and display a message editing interface for sending a message to a target contact on the first touch screen in response to a touch instruction for the message sending control and the target contact selected via a touch instruction for the contact control.

According to the embodiments of the present disclosure, the target control of the event to be executed is displayed on the second touch screen of the mobile terminal in response to an existence of the vertical downward component in the positive normal direction of the first touch screen of the mobile terminal. A determination may be made on whether the rotation parameter value of the mobile terminal is greater than the preset rotation threshold value in response to receiving the touch instruction for the target control, and the event to be executed will be executed according to the touch instruction based on a determination that the rotation parameter value of the mobile terminal is greater than the preset rotation threshold value. The embodiments of the present disclosure achieve technical effects of triggering the corresponding control for the event to be executed and executing the corresponding operation in the process of picking up the mobile phone by the user, according to the operation of touching the control displayed on the second touch screen and the motion of rotating the mobile phone in the process of picking up the mobile phone, thereby simplifying process and offering convenience for the users.

### BRIEF DESCRIPTION OF THE DRAWINGS

In order to illustrate the technical solutions of embodiments of the present disclosure more clearly, the drawings used in the embodiments will be briefly described below. It will be apparent that the drawings described in the following are merely some embodiments of the present disclosure, and it will be apparent to those skilled in the art that other drawings can be obtained from the drawings without any creative work.
FIG. 1 is a schematic flow diagram illustrating an information processing method according to an embodiment of the present disclosure;
FIG. 2 is a schematic flow diagram illustrating a call request scenario of an information processing method according to an embodiment of the present disclosure;
FIG. 3 is a schematic flow diagram illustrating a message request scenario of an information processing method according to an embodiment of the present disclosure;
FIG. 4 is a schematic flow diagram illustrating control position adjustment of an information processing method according to an embodiment of the present disclosure;
FIG. 5 is a schematic flow diagram illustrating an information processing method according to another embodiment of the present disclosure;
FIG. 6 is a schematic diagram illustrating a message sending scenario of an information processing method according to an embodiment of the present disclosure;
FIG. 7 is a schematic structural diagram illustrating an information processing device according to an embodiment of the present disclosure;
FIG. 8a is a schematic structural diagram illustrating a display module of an information processing device according to an embodiment of the present disclosure;
FIG. 8b is a schematic structural diagram illustrating an executing module of an information processing device according to an embodiment of the present disclosure;
FIG. 9a is a schematic structural diagram illustrating a display module of an information processing device according to another embodiment of the present disclosure;
FIG. 9b is a schematic structural diagram illustrating an executing module of an information processing device according to another embodiment of the present disclosure;
FIG. 10a is a schematic structural diagram illustrating a display module of an information processing device according to another embodiment of the present disclosure;
FIG. 10b is a schematic structural diagram illustrating a touch instruction receiving module of an information processing device according to an embodiment of the present disclosure;
FIG. 11a is a schematic structural diagram illustrating a first display sub-unit of an information processing device according to an embodiment of the present disclosure;
FIG. 11b is a schematic structural diagram illustrating a second display sub-unit of an information processing device according to an embodiment of the present disclosure;
FIG. 11c is a schematic structural diagram illustrating an executing module of an information processing device according to another embodiment of the present disclosure;
FIG. 12a is a schematic diagram illustrating one of call answering scenarios of an information processing method according to an embodiment of the present disclosure;
FIG. 12b is a schematic diagram illustrating one of call answering scenarios of an information processing method according to an embodiment of the present disclosure;
FIG. 12c is a schematic diagram illustrating one of call answering scenarios of an information processing method according to an embodiment of the present disclosure;
FIG. 13a is a schematic diagram illustrating one of message reading scenarios of an information processing method according to an embodiment of the present disclosure;
FIG. 13b is a schematic diagram illustrating one of message reading scenarios of an information processing method according to an embodiment of the present disclosure;
FIG. 13c is a schematic diagram illustrating one of message reading scenarios of an information processing method according to an embodiment of the present disclosure;
FIG. 14a is a schematic diagram illustrating one of message sending scenarios of an information processing method according to an embodiment of the present disclosure; and
FIG. 14b is a schematic diagram illustrating one of message sending scenarios of an information processing method according to an embodiment of the present disclosure.

### DETAILED DESCRIPTION

Technical solutions in the embodiments of the present disclosure will be described clearly and completely hereinafter with reference to the accompanying drawings in the embodiments of the present disclosure. Apparently, the described embodiments are merely some rather than all embodiments of the present disclosure. All other embodiments obtained by those of ordinary skill in the art based on the embodiments of the present disclosure without creative efforts shall fall within the protection scope of the present disclosure.

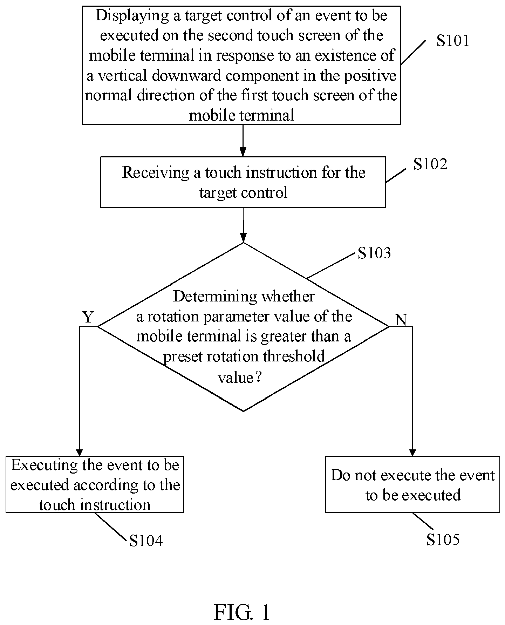

FIG. 1 is a schematic flow diagram illustrating an information processing method according to an embodiment of the present disclosure. The information processing method is applied to a mobile terminal provided with a first touch screen and a second touch screen. The first touch screen is located on a front surface of the mobile terminal and the second touch screen is located on a rear surface or a side surface of the mobile terminal. The information processing method includes the following steps.

At block S101, a target control of an event to be executed may be displayed on the second touch screen of the mobile terminal, when there is a vertical downward component in a positive normal direction of the first touch screen of the mobile terminal.

Specifically , the first touch screen of the mobile terminal refers to a main display interface of the mobile terminal. If the mobile terminal is a smart phone, the first touch screen refers to an interface for displaying contents. The existence of the vertical downward component in the positive normal direction of the first touch screen, refers to that the mobile terminal may be inverted on a desktop, or the first touch screen may face the ground when the mobile terminal is placed, where the first touch screen is hidden from view and is not directly accessible to a user.

The mobile terminal may be a smart phone with a flexible display screen. The display screen of the smart phone further extends to the side surface and ends at a junction of the side surface and the rear surface. Alternatively, the display screen may also extend to cover the entire rear surface. The side surface of the mobile terminal is a convex curved surface, such that the user can get, for example, a message received by the mobile terminal, through the second touch screen on the side surface when the rear surface of the mobile terminal faces upwards.

At block SI02, a touch instruction for the target control may be received.

Specifically, the touch instruction is directed to the target control, and the touch instruction satisfies conditions for triggering the target control. In this implementation, the conditions include touching duration and touching position.

At block S103, a determination may be made on whether a rotation parameter value of the mobile terminal is greater than a preset rotation threshold value.

Specifically, a determination may be made on whether the rotation parameter value of the mobile terminal is greater than the preset rotation threshold value in response to receiving the touch instruction for the target control.

In an application scenario, it may be considered that, the user gets a new message notification or push through the second touch screen on the side surface or the rear surface of the mobile terminal inverted on the desktop. In the process of picking up the mobile terminal, the user may touch the target control which is applied for the push displayed on the second touch screen, disposed on the side surface or on the rear surface, and the target control is then triggered. In the meanwhile, the mobile terminal is rotated with the rotation parameter value in the process of picking up the mobile terminal. The rotation parameter value is compared with the preset rotation threshold value of the mobile phone, and a determination is made on whether the rotation parameter value of the mobile terminal is greater than the preset rotation threshold value, so as to determine whether to trigger the target control and perform a corresponding operation.

At block S104, the event to be executed may be executed according to the touch instruction.

Specifically, when it is determined that the rotation parameter value of the mobile terminal is greater than the preset rotation threshold value, a condition for executing the event to be executed has been satisfied. In this case, the mobile terminal executes the event to be executed.

At block SI05, the event to be executed may not be executed.

Specifically, when it is determined that the rotation parameter value of the mobile terminal is not greater than the preset rotation threshold value, the event to be executed may not be executed. The mobile terminal may maintain an initial state without performing any operation and may also display a notification of failure of executing the event to be executed.

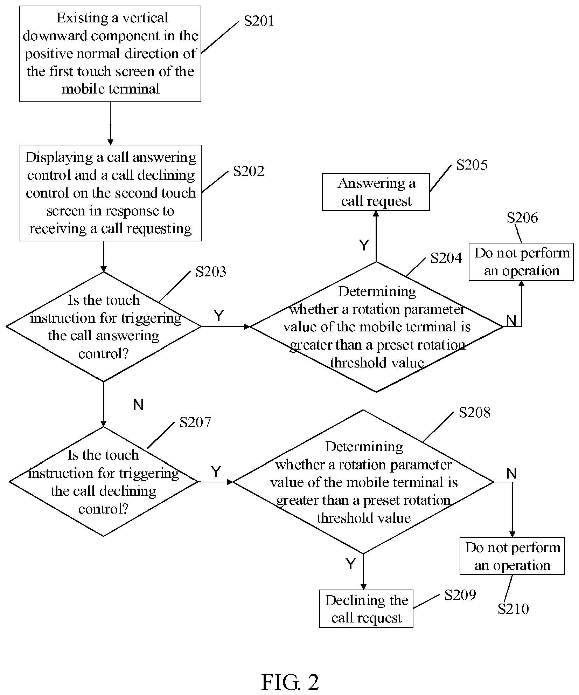

FIG. 2 is a schematic flow diagram illustrating a call request scenario of an information processing method according to an embodiment of the present disclosure, which includes the following steps.

At block S201, there exists a vertical downward component in the positive normal direction of the first touch screen of the mobile terminal.

Specifically, the first touch screen of the mobile terminal refers to a main display interface of the mobile terminal. When the mobile terminal is a smart phone, the first touch screen refers to an interface for displaying contents. The existence of the vertical downward component in the positive normal direction of the first touch screen, refers to that the mobile terminal may be inverted on the desktop, or the first touch screen may face the ground when the mobile terminal is placed, where the first touch screen is hidden from view and is not directly accessible to the user.

At block S202, a call answering control and a call declining control may be displayed on the second touch screen of the mobile terminal in response to receiving a call request.

Specifically, when the mobile terminal (i.e., a mobile phone) is inverted on the desktop, the call answering control and the call declining control will be displayed on the second touch screen of the mobile phone in response to the call request received by the mobile terminal (that is, in response to an incoming call).

At block S203, a determination may be made on whether the touch instruction is a touch instruction for the call answering control.

Specifically, when the call answering control and the call declining control have been displayed on the second touch screen of the mobile terminal, the touch instruction may be received, and it may then be determined whether the touch instruction is a touch instruction for triggering the call answering control.

At block S204, a determination may be made on whether a rotation parameter value of the mobile terminal is greater than a preset rotation threshold value.

Specifically, it is further determined whether the rotation parameter value of the mobile terminal is greater than the preset rotation threshold value based on a determination at block S203 that the touch instruction is a touch instruction for triggering the call answering control. In a scenario, an incoming call notification is got through the second touch screen of the mobile terminal inverted on the desktop, and the user then touches the call answering control displayed on the second touch screen in the process of picking up the mobile terminal.

At block S205, the call request may be answered by the user.

Specifically, the call request is answered based on a determination at block S204 that the rotation parameter value of the mobile terminal is greater than the preset rotation threshold value. In a scenario, the user can pick up the mobile phone while touching the call answering control and answer the call request in the process of picking up the mobile phone without additional operations of clicking and sliding, thereby simplifying process and offering convenience for the users.

At block S206, the event to be executed may not be executed.

Specifically, no operation is executed based on a determination at block S204 that the rotation parameter value of the mobile terminal is not greater than the preset rotation threshold value, and the user can answer the call request through other operations such as sliding or clicking.

At block S207, a determination may be made on whether the touch instruction is a touch instruction for the call declining control.

Specifically, when the call answering control and the call declining control have been displayed on the second touch screen of the mobile terminal, the touch instruction may be received, and it may then be determined that whether the touch instruction is a touch instruction for triggering the call declining control.

At block S208, a determination may be made on whether a rotation parameter value of the mobile terminal is greater than a preset rotation threshold value.

Specifically, it is further determined whether the rotation parameter value of the mobile terminal is greater than the preset rotation threshold value based on a determination at block S207 that the touch instruction is a touch instruction for the triggering call declining control. In a scenario, an incoming call notification displayed on the second touch screen of the mobile terminal inverted on the desktop is got, and the user then touches the call declining control displayed on the second touch screen in the process of picking up the mobile terminal.

At block S209, the call request may be declined by the user.

Specifically, the call request is declined based on a determination at block S208 that the rotation parameter value of the mobile terminal is greater than the preset rotation threshold value. In a scenario, the user can pick up the mobile phone while touching the call declining control and decline the call request in the process of picking up the mobile phone without additional operations of clicking and sliding, thereby simplifying process and offering convenience for the users.

At block S210, the event to be executed may not be executed.

Specifically, no operation is executed based on a determination at block S208 that the rotation parameter value of the mobile terminal is not greater than the preset rotation threshold value, and the user can decline the call request through other operations such as sliding or clicking.

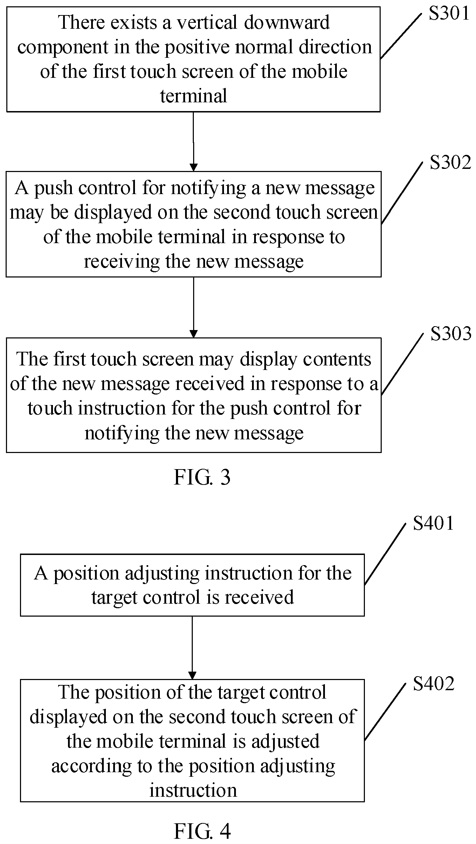

FIG. 3 is a schematic flow diagram illustrating a message request scenario of an information processing method according to an embodiment of the present disclosure, which includes the following steps.

At block S301, there exists a vertical downward component in the positive normal direction of the first touch screen of the mobile terminal.

Specifically, the first touch screen of the mobile terminal refers to a main display interface of the mobile terminal. When the mobile terminal is a smart phone, the first touch screen refers to an interface for illustrated contents. The existence of the vertical downward component in the positive normal direction of the first touch screen, indicates that the mobile terminal may be inverted on the desktop, or the first touch screen may face the ground when the mobile terminal is placed, where the first touch screen is hidden from view and is not directly accessible to the user.

At block S302, a push control for notifying a new message may be displayed on the second touch screen of the mobile terminal in response to receiving the new message.

Specifically, when the mobile terminal (i.e., a mobile phone) is inverted on the desktop, the push control for notifying the new message will be displayed on the second touch screen of the mobile phone in response to receiving a new message notification (for example, a text message notification, as well as a message or a push of a software application) by the mobile terminal.

At block S303, the first touch screen may display contents of the new message received in response to a touch instruction for the push control for notifying the new message.

Specifically, a determination is made on whether the rotation parameter value of the mobile terminal is greater than the preset rotation threshold value in response to receiving the touch instruction for the push control for notifying the new message. The contents of the new message received are displayed on the first touch screen based on a determination that the rotation parameter value of the mobile terminal is greater than the preset rotation threshold value.

FIG. 4 is a schematic flow diagram illustrating step of adjusting control position of the information processing method according to an embodiment of the present disclosure. The information processing method includes the following steps.

At block S401, a position adjusting instruction for the target control is received.

Specifically, a position where the target control displays on the second touch screen of the mobile terminal can be adjusted, so as to facilitate users with different habits of handling the mobile terminal. For example, the users can send the position adjusting instruction for the target control by entering a settings directory of the mobile terminal.

At block S402, the position of the target control displayed on the second touch screen of the mobile terminal is adjusted according to the position adjusting instruction.

Specifically, the mobile terminal can receive the position adjusting instruction and adjust the position of the target control displayed on the second touch screen of the mobile terminal, so as to offer convenience for the users.

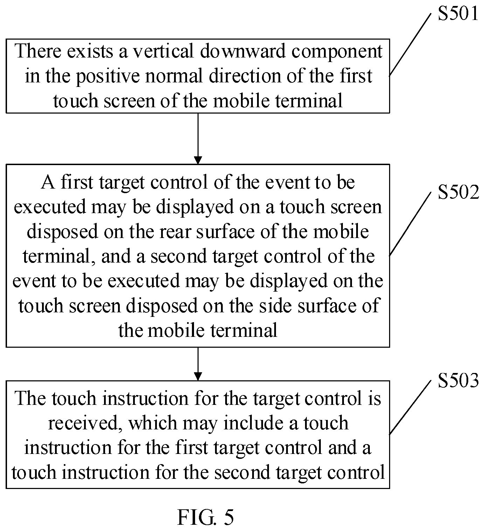

FIG. 5 is a schematic flow diagram illustrating an information processing method according to another embodiment of the present disclosure. The information processing method includes the following steps.

At block S501, there exists a vertical downward component in the positive normal direction of the first touch screen of the mobile terminal.

Specifically, the first touch screen of the mobile terminal refers to a main display interface of the mobile terminal. In the case that the mobile terminal is a smart phone, the first touch screen refers to an interface for displaying contents. The existence of the vertical downward component in the positive normal direction of the first touch screen, refers to that the mobile terminal may be inverted on the desktop, or the first touch screen may face the ground when the mobile terminal is placed, where the first touch screen is hidden from view and is not directly accessible to the user.

At block S502, a first target control of the event to be executed may be displayed on a touch screen disposed on the rear surface of the mobile terminal, and a second target control of the event to be executed may be displayed on the touch screen disposed on the side surface of the mobile terminal.

Specifically, for example, when a second touch screen is disposed on the rear surface and the side surface of the mobile terminal, the first target control of the event to be executed is displayed on the second touch screen disposed on the rear surface of the mobile terminal, and the second target control of the event to be executed is displayed on the second touch screen disposed on the side surface of the mobile terminal. The first target control and the second target control may be respectively configured to receive different digits of a lock screen password, and may also be different controls required to trigger a same application.

At block S503, the touch instruction for the target control is received, which may include a touch instruction for the first target control and a touch instruction for the second target control.

As an implementation of the present application, the first target control and the second target control may be configured to receive touch instructions simultaneously or sequentially, so as to trigger the first target control and the second target control.

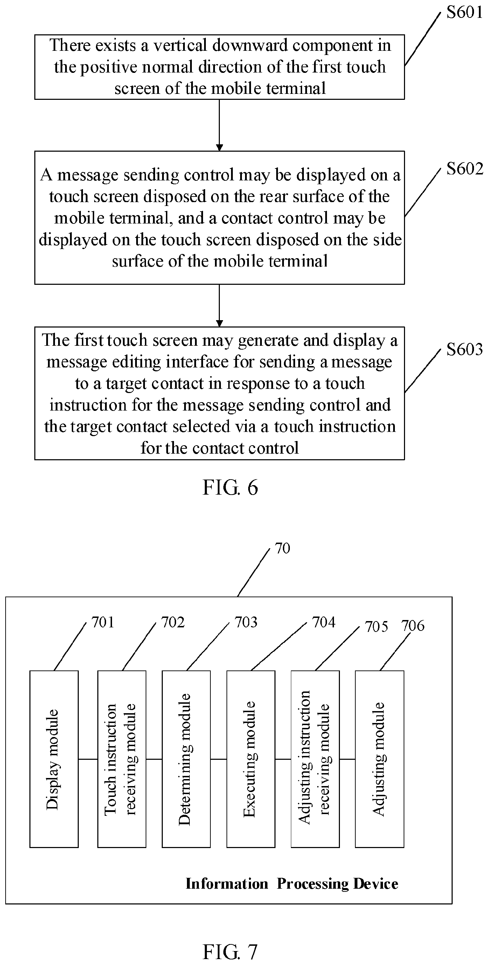

FIG. 6 is a schematic diagram illustrating a message sending scenario of an information processing method according to an embodiment of the present disclosure. The information processing method includes the following steps.

At block S601, there exists a vertical downward component in the positive normal direction of the first touch screen of the mobile terminal.

Specifically, the first touch screen of the mobile terminal refers to a main display interface of the mobile terminal. When the mobile terminal is a smart phone, the first touch screen refers to an interface for displaying contents. The existence of the vertical downward component in the positive normal direction of the first touch screen, refers to that the mobile terminal may be inverted on the desktop, or the first touch screen may face the ground when the mobile terminal is placed, where the first touch screen is hidden from view and is not directly accessible to the user.

At block 602, a message sending control may be displayed on a touch screen disposed on the rear surface of the mobile terminal, and a contact control may be displayed on the touch screen disposed on the side surface of the mobile terminal.

Specifically, when the user wants to send a message, the message sending control can be displayed on the touch screen disposed on the rear surface of the mobile terminal, and the contact control can be displayed on the touch screen disposed on the side surface of the mobile terminal.

At block S603, the first touch screen may generate and display a message editing interface for sending a message to a target contact in response to a touch instruction for the message sending control and the target contact selected via a touch instruction for the contact control.

Specifically, the user can trigger the message sending control on the second touch screen disposed on the rear surface of the mobile terminal, and simultaneously trigger and display the contact control on the second touch screen disposed on the side surface of the mobile terminal and select the target contact, and a determination is further made on whether the rotation parameter value of the mobile terminal is greater than the preset rotation threshold value. And then, the user can enter the message editing interface for sending a message to the target contact based on a determination that the rotation parameter value of the mobile terminal is greater than the preset rotation threshold value.

FIG. 7 is a schematic structural diagram illustrating an information processing device according to an embodiment of the present disclosure. As illustrated in FIG. 7, the information processing device may include a display module 701, a touch instruction receiving module 702, a determining module 703, an executing module 704, an adjusting instruction receiving module 705, and an adjusting module 706.

The display module 701 is configured to display a target control of an event to be executed on a second touch screen of a mobile terminal, when there is a vertical downward component in a positive normal direction of a first touch screen of the mobile terminal.

The touch instruction receiving module 702 is configured to receive a touch instruction for the target control.

The determining module 703 is configured to determine whether a rotation parameter value of the mobile terminal is greater than a preset rotation threshold value in response to receiving the touch instruction for the target control by the touch instruction receiving module 702.

The executing module 704 is configured to execute the event to be executed according to the touch instruction based on a determination result of the determining module 703 that the rotation parameter value of the mobile terminal is greater than the preset rotation threshold value.

The adjusting instruction receiving module 705 is configured to receive a position adjusting instruction for the target control.

The adjusting module 706 is configured to adjust the position of the target control displayed on the second touch screen of the mobile terminal according to the position adjusting instruction.

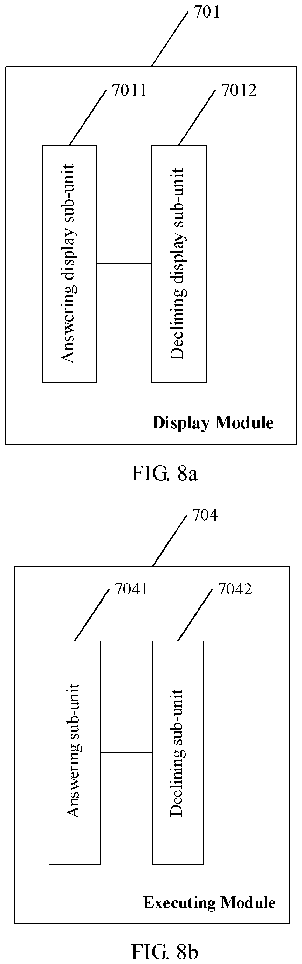

FIG. 8a is a schematic structural diagram illustrating a display module of an information processing device according to an embodiment of the present disclosure. As illustrated in FIG. 8a, the display module 701 may include an answering display sub-unit 7011 and a declining display sub-unit 7012.

The answering display sub-unit 7011 is configured to display a call answering control in response to receiving a call request.

The declining display sub-unit 7012 is configured to display a call declining control in response to receiving the call request.

FIG. 8b is a schematic structural diagram illustrating an executing module of an information processing device according to an embodiment of the present disclosure. As illustrated in FIG. 8b, the executing module 704 may include an answering sub-unit 7041 and a declining sub-unit 7042.

The answering sub-unit 7041 is configured to answer a call request when the touch instruction is for triggering the call answering control.

The declining sub-unit 7042 is configured to decline the call request when the touch instruction is for triggering the call declining control.

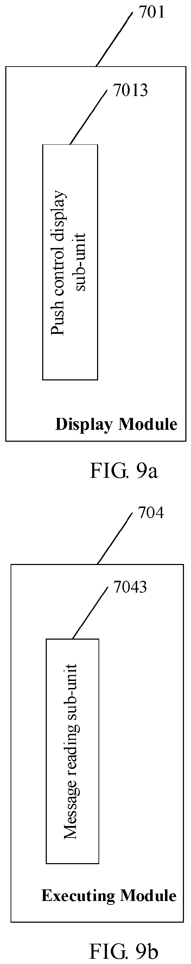

FIG. 9a is a schematic structural diagram illustrating a display module of an information processing device according to another embodiment of the present disclosure. As illustrated in FIG. 9a, the display module 701 may include a push control display sub-unit 7013.

The push control display sub-unit 7013 is configured to display a push control for notifying a new message in response to receiving the new message.

FIG. 9b is a schematic structural diagram illustrating an executing module of an information processing device according to another embodiment of the present disclosure. As illustrated in FIG. 9b, the executing module 704 may include a message reading sub-unit 7043.

The message reading sub-unit 7043 is configured to display contents of the new message received on the first touch screen in response to a touch instruction for the push control for notifying the new message.

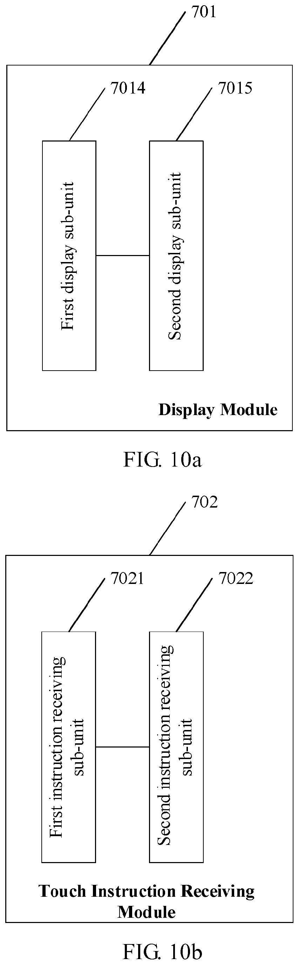

FIG. 10a is a schematic structural diagram illustrating a display module of an information processing device according to another embodiment of the present disclosure. As illustrated in FIG. 10a, the display module 701 may include a first display sub-unit 7014 and a second display sub-unit 7015.

The first display sub-unit 7014 is configured to display a first target control of the event to be executed on the second touch screen disposed on the rear surface of the mobile terminal.

The second display sub-unit 7015 is configured to display a second target control of the event to be executed on the second touch screen disposed on the side surface of the mobile terminal.

FIG. 10b is a schematic structural diagram illustrating a touch instruction receiving module of an information processing device according to an embodiment of the present disclosure. As illustrated in FIG. 10b, the touch instruction receiving module 702 may include a first instruction receiving sub-unit 7021 and a second instruction receiving sub-unit 7022.

The first instruction receiving sub-unit 7021 is configured to receive a touch instruction for the first target control.

The second instruction receiving sub-unit 7022 is configured to receive a touch instruction for the second target control.

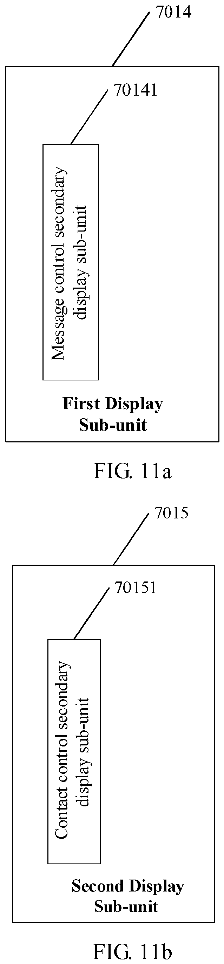

FIG. 11a is a schematic structural diagram illustrating a first display sub-unit of an information processing device according to an embodiment of the present disclosure. As illustrated in FIG. 11a, the first display sub-unit 7014 may include a message control secondary display sub-unit 70141.

The message control secondary display sub-unit 70141 is configured to display a message sending control on the second touch screen disposed on the rear surface of the mobile terminal.

FIG. 11b is a schematic structural diagram illustrating a second display sub-unit of an information processing device according to an embodiment of the present disclosure. As illustrated in FIG. 11b, the second display sub-unit 7015 may include a contact control secondary display sub-unit 70151.

The contact control secondary display sub-unit 70151 is configured to display a contact control on the second touch screen disposed on the side surface of the mobile terminal.

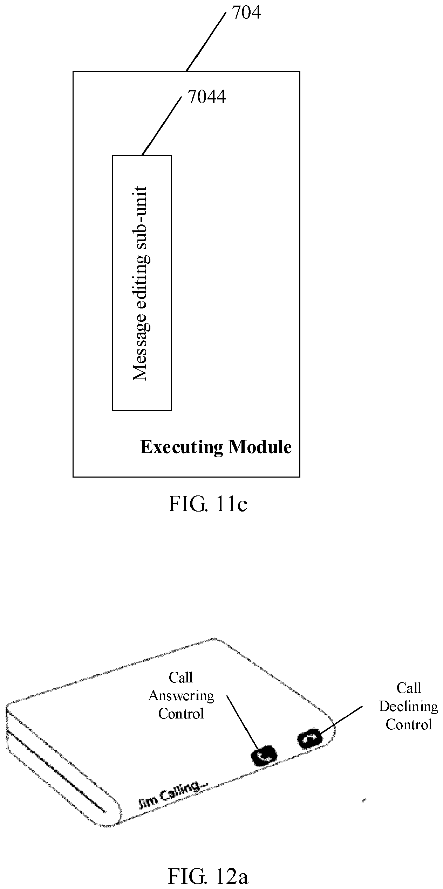

FIG. 11c is a schematic structural diagram illustrating an executing module of an information processing device according to yet another embodiment of the present disclosure. As illustrated in FIG. 11c, the executing module 704 may include a message editing sub-unit 7044.

The message editing sub-unit 7044 is configured to generate and display a message editing interface for sending a message to a target contact on the first touch screen in response to a touch instruction for the message sending control and the target contact selected via a touch instruction for the contact control.

Implementation manners of the information processing method according to the embodiments of present disclosure will be illustrated hereinafter with reference to scenario schematic diagrams.

FIG. 12a is a schematic diagram illustrating one of call answering scenarios of an information processing method according to an embodiment of the present disclosure.

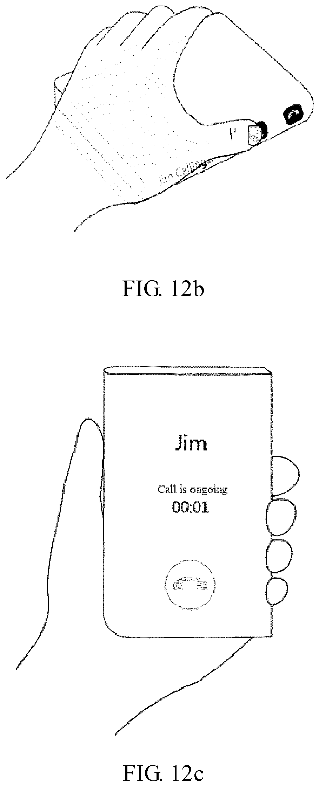

When a mobile terminal, which is a mobile phone, is inverted on a desk, there exists a vertical downward component in the positive normal direction of a first touch screen. As illustrated in FIG. 12a, a call answering control and a call declining control can be displayed on a second touch screen disposed on a side surface of the mobile terminal in response to receiving an incoming call. As illustrated in FIG. 12b, a user can pick up the mobile phone and touch the call answering control by the thumb when viewing the call answering control and the call declining control displayed on the second touch screen. The mobile phone will be rotated in the process of being picked up, and when a rotation parameter value is greater than a preset rotation threshold value and the first touch screen of the mobile phone faces the user, the mobile phone is already connected and the user can answer the call request directly, as illustrated in FIG. 12c. In this way, the user can trigger the answering call function in the process of picking up the mobile phone, and when the first touch screen faces the user, the call request can be directly answered without additional sliding or clicking operations, thereby simplifying process and offering convenience for the users.

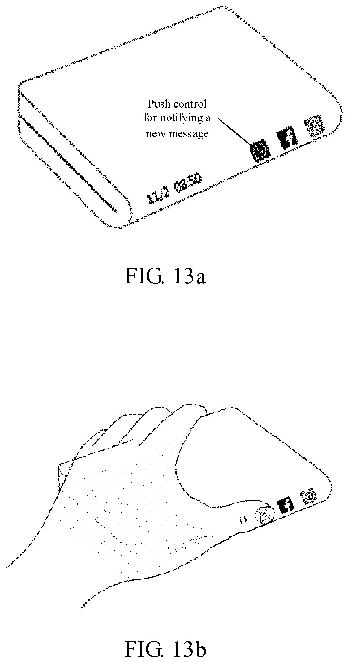

FIG. 13a is a schematic diagram illustrating one of message reading scenarios of an information processing method according to an embodiment of the present disclosure.

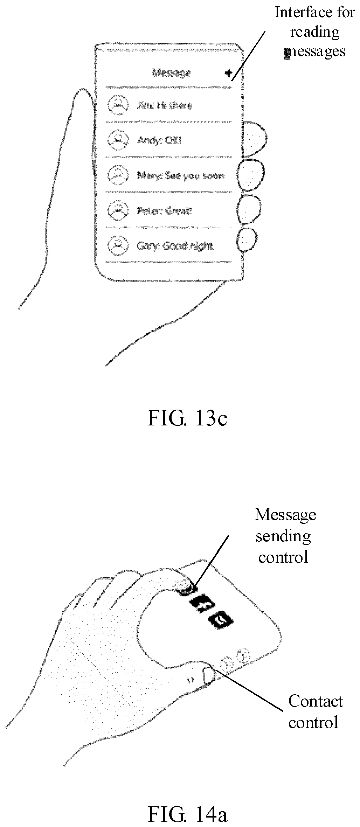

When a mobile terminal, which is a mobile phone, is inverted on a desk, there exists a vertical downward component in the positive normal direction of a first touch screen. As illustrated in FIG. 13a, a push control for notifying a new message can be displayed on a second touch screen disposed on a side surface of the mobile terminal in response to receiving a new message notification. As illustrated in FIG. 13b, a user can pick up the mobile phone and meanwhile touch the push control for notifying the new message by the thumb. The mobile phone will be rotated in the process of being picked up, and a rotation parameter value is greater than a preset rotation threshold value. When the first touch screen of the mobile phone faces the user, contents of the new message have already been displayed on the first touch screen of the mobile phone, such that the user can read the new message directly, as illustrated in FIG. 13c. In this way, it is possible to simplify process and offer convenience for the users.

FIG. 14a is a schematic diagram illustrating another message sending scenario of an information processing method according to an embodiment of the present disclosure.

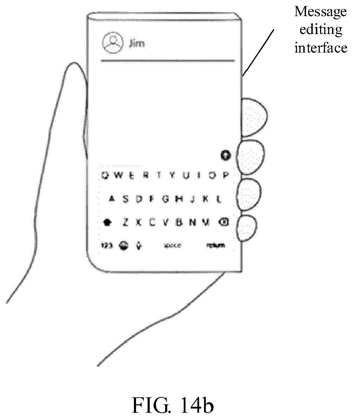

When a mobile terminal, which is a mobile phone, is inverted on a desk, there exists a vertical downward component in the positive normal direction of a first touch screen. In a case that a user wants to send a message, a message sending control displayed on a second touch screen disposed on a rear surface of the mobile terminal is triggered, and simultaneously, a contact control on a second touch screen disposed on a side surface of the mobile terminal is triggered to select a target contact, as illustrated in FIG. 14a. The mobile phone will be rotated in the process of being picked up, and a rotation parameter value is greater than a preset rotation threshold value. When the first touch screen of the mobile phone faces the user, a message editing interface has been displayed on the first touch screen, so that the user can edit a message directly, as shown in FIG. 14b.

The foregoing are only some applications of the embodiments of the present disclosure, and more functions can be extended through the second touch screen of the mobile terminal in practice, for example, dialing a specific contact call, opening a feature page of an application software, verifying the lock screen password, and the like. In this way, the user can enter the corresponding control for the event to be executed in the process of picking up the mobile phone, thereby simplifying process and offering convenience for the users.

According to embodiments of the present disclosure, the target control of the event to be executed is displayed on the second touch screen of the mobile terminal in response to the existence of the vertical downward component in the positive normal direction of the first touch screen of the mobile terminal, and the rotation parameter value of the mobile terminal is then determined whether is greater than the preset rotation threshold value in response to receiving the touch instruction for the target control, and thereafter the event to be executed will be executed according to the touch instruction based on a determination that the rotation parameter value of the mobile terminal is greater than the preset rotation threshold value. The user can enter a corresponding control for the event to be executed in the process of picking up the mobile phone since the control displayed on the second touch screen has been triggered by the user while handling the mobile phone and a rotation motion has been applied to the mobile phone, thereby simplifying process and offering convenience for the users. For example, when viewing a control for notifying message displayed on the second touch screen, the user only needs to trigger the control for notifying message in the process of picking up the mobile phone. That is to say, the corresponding control for the event to be executed can be triggered and the corresponding operation can be performed in the process of picking up the mobile phone, thereby simplifying process and offering convenience for the users. It solves the problem in the related art where the user is subject to cumbersome operations to trigger the corresponding control to execute the event to be executed. It will be appreciated that embodiments of the present disclosure are also applicable to foldable flexible mobile phones.

It is to be noted that, for the sake of simplicity, the foregoing method embodiments are described as a series of action combinations, however, it will be appreciated by those skilled in the art that the present disclosure is not limited by the sequence of actions described. According to the present disclosure, certain steps or operations may be performed in other order or simultaneously. Besides, it will be appreciated by those skilled in the art that the embodiments described in the specification are exemplary embodiments and the actions and modules involved are not necessarily essential to the present disclosure.

In the foregoing embodiments, the description of each embodiment has its own emphasis. For the parts not described in detail in one embodiment, reference may be made to related descriptions in other embodiments.

In the embodiments of the disclosure, it should be understood that, the apparatus disclosed in embodiments provided herein may be implemented in other manners. For example, the device/apparatus embodiments described above are merely illustrative; for instance, the division of the unit is only a logical function division and there can be other manners of division during actual implementations, for example, multiple modules or components may be combined or may be integrated into another system, or some features may be ignored, omitted, or not performed. In addition, coupling or communication connection between each illustrated or discussed component may be direct coupling or communication connection, or may be indirect coupling or communication among devices or modules via some interfaces, and may be electrical connection, mechanical connection, or other forms of connection.

The modules described as separate components may or may not be physically separated, the components illustrated as modules may or may not be physical modules, that is, they may be in the same place or may be distributed to multiple network elements. All or part of the modules may be selected according to actual needs to achieve the purpose of the technical solutions of the embodiments.

In addition, the functional modules in various embodiments of the present disclosure may be integrated into one processing unit, or each unit may be physically present, or two or more modules may be integrated into one unit. The above-mentioned integrated unit can be implemented in the form of hardware or a software function unit.

The integrated unit may be stored in a computer-readable memory when it is implemented in the form of a software functional unit and is sold or used as a separate product. Based on such understanding, the technical solutions of the present disclosure essentially, or the part of the technical solutions that contributes to the related art, or all or part of the technical solutions, may be embodied in the form of a software product which is stored in a memory and includes instructions for causing a computer device (which may be a personal computer, a server, or a network device and so on) to perform all or part of the steps described in the various embodiments of the present disclosure. The memory includes various medium capable of storing program codes, such as a USB (universal serial bus) flash disk, a read-only memory (ROM), a random access memory (RAM), a removable hard disk, Disk, compact disc (CD), or the like.

Although the above embodiments are used only to explain the technical solution of the present disclosure, the scope of the present disclosure is not limited thereto. While the present disclosure has been described in detail above with reference to the exemplary embodiments, those of ordinary skill in the art should appreciate that the technical solutions in the foregoing respective embodiments can still be modified or some technical features thereof can be equivalently substituted; and these modifications or substitutions do not make the nature of corresponding technical solutions departing from the scope of the technical solutions in the respective embodiments.

## Claims

1. An information processing method, applicable to a mobile terminal provided with a first touch screen and a second touch screen, wherein the first touch screen is located on a front surface of the mobile terminal and the second touch screen is located on a rear surface or a side surface of the mobile terminal, the information processing method comprising:
displaying a target control of an event to be executed on the second touch screen in response to an existence of a vertical downward component in a positive normal direction of the first touch screen;
determining whether a rotation parameter value of the mobile terminal is greater than a preset rotation threshold value in response to receiving a touch instruction for the target control; and
executing the event to be executed according to the touch instruction based on a determination that the rotation parameter value of the mobile terminal is greater than the preset rotation threshold value.

2. The information processing method of claim 1, wherein displaying the target control of the event to be executed on the second touch screen comprises:
displaying a call answering control and a call declining control on the second touch screen in response to receiving a call request;
wherein executing the event to be executed according to the touch instruction comprises one of:
answering the call request when the touch instruction is for triggering the call answering control; and
declining the call request when the touch instruction is for triggering the call declining control.

3. The information processing method of claim 1, wherein displaying the target control of the event to be executed on the second touch screen comprises:
displaying a push control for notifying a new message on the second touch screen in response to receiving the new message;
wherein executing the event to be executed according to the touch instruction comprises:
displaying contents of the new message received on the first touch screen in response to a touch instruction for the push control for notifying the new message.

4. The information processing method of claim 1, further comprising:
receiving a position adjusting instruction for the target control; and
adjusting a position of the target control displayed on the second touch screen of the mobile terminal in response to the position adjusting instruction.

5. The information processing method of claim 1, wherein displaying the target control of the event to be executed on the second touch screen comprises:
displaying a first target control of the event to be executed on the second touch screen disposed on the rear surface of the mobile terminal, and displaying a second target control of the event to be executed on the second touch screen disposed on the side surface of the mobile terminal;
wherein the touch instruction for the target control comprises a touch instruction for the first target control and a touch instruction for the second target control.

6. The information processing method of claim 5, wherein
displaying the first target control of the event to be executed comprises:
displaying a message sending control on the second touch screen disposed on the rear surface of the mobile terminal;
displaying the second target control of the event to be executed comprises:
displaying a contact control on the second touch screen disposed on the side surface of the mobile terminal; and
executing the event to be executed according to the touch instruction comprises:
generating and displaying a message editing interface for sending a message to a target contact on the first touch screen in response to a touch instruction for the message sending control and the target contact selected via a touch instruction for the contact control.

7. An information processing device, applicable to a mobile terminal provided with a first touch screen and a second touch screen, wherein the first touch screen is located on a front surface of the mobile terminal and the second touch screen located on a rear surface or a side surface of the mobile terminal, the information processing device comprising:
a display module, configured to display a target control of an event to be executed on the second touch screen in response to an existence of a vertical downward component in a positive normal direction of the first touch screen;
a touch instruction receiving module, configured to receive a touch instruction for the target control;
a determining module, configured to determine whether a rotation parameter value of the mobile terminal is greater than a preset rotation threshold value in response to receiving the touch instruction for the target control by the touch instruction receiving module; and
an executing module, configured to execute the event to be executed according to the touch instruction based on a determination result of the determining module that the rotation parameter value of the mobile terminal is greater than the preset rotation threshold value.

8. The information processing device of claim 7, wherein the display module comprises:
an answering display sub-unit, configured to display a call answering control in response to receiving a call request; and
a declining display sub-unit, configured to display a call declining control in response to receiving the call request;
wherein the executing module comprises:
an answering sub-unit, configured to answer the call request when the touch instruction is for triggering the call answering control; and
a declining sub-unit, configured to decline the call request when the touch instruction is for triggering the call declining control.

9. The information processing device of claim 7, wherein the display module comprises:
a push control display sub-unit, configured to display a push control for notifying a new message in response to receiving the new message;
wherein the executing module comprises:
a message reading sub-unit, configured to display contents of the new message received on the first touch screen in response to a touch instruction for the push control for notifying the new message.

10. The information processing device of claim 7, further comprising:
an adjusting instruction receiving module, configured to receive a position adjusting instruction for the target control; and
an adjusting module, configured to adjust a position of the target control displayed on the second touch screen of the mobile terminal according to the position adjusting instruction.

11. The information processing device of claim 7, wherein the display module comprises:
a first display sub-unit, configured to display a first target control of the event to be executed on the second touch screen disposed on the rear surface of the mobile terminal; and
a second display sub-unit, configured to display a second target control of the event to be executed on the second touch screen disposed on the side surface of the mobile terminal;
wherein the touch instruction receiving module comprises:
a first instruction receiving sub-unit, configured to receive a touch instruction for the first target control; and
a second instruction receiving sub-unit, configured to receive a touch instruction for the second target control.

12. The information processing device of claim 11, wherein
the first display sub-unit comprises:
a message control secondary display sub-unit, configured to display a message sending control on the second touch screen disposed on the rear surface of the mobile terminal;
the second display sub-unit comprises:
a contact control secondary display sub-unit, configured to display a contact control on the second touch screen disposed on the side surface of the mobile terminal; and
the executing module comprises:
a message editing sub-unit, configured to generate and display a message editing interface for sending a message to a target contact on the first touch screen in response to a touch instruction for the message sending control and the target contact selected via a touch instruction for the contact control.
